# EUROPEAN PATENT APPLICATION

(11) **EP 2 139 045 A1**
(43) Date of publication of application: **30.12.2009**
(21) Application number: 08779150.5
(22) Date of filing: 09.04.2008
(51) Int. Cl.: H01L 31/04

(54) **ELECTROMAGNETIC EMISSION CONVERTER**

(71) Applicant: OOO "Novye Energeticheskie Tehnologii", Moscow 107031 (RU)
(72) Inventor: PROTZENKO, Igor, Moscow 127055 (RU); RUDOI, Viktor Moiseevich, Moscow 119311 (RU); ZAIMDOROGA, Oleg Antonovich, Dubna 141980 (RU)
(74) Representative: Reichert, Werner Franz
(86) International application number: PCT/RU2008/000076
(87) International publication number: WO 2009/126056

(57) **Abstract**

The invention relates to converters of the energy of electromagnetic radiation to electrical energy and may be used in the production of solar photocells. The converter according to the invention contains at least one photosensitive layer that achieves the generation of a photocurrent through the absorption of electromagnetic radiation, as well as collector electrodes. At the same time, the converter also contains metallic nanoparticles, the size of which is on the order of, or less than, the wavelength in the maximum of the spectrum of the incident radiation, that achieve the concentration of the incident radiation in the near-field around the nanoparticles and the generation of a photocurrent through the absorption of said radiation. Intensification of the photocurrent and enhancement of the efficiency of the converter are achieved as a result.

## Description

### FIELD OF THE INVENTION

The invention relates to converters of the energy of electromagnetic radiation to electrical energy and may be used in the production of solar photocells.

### BACKGROUND OF THE INVENTION

At the present time a relatively large number of industrially produced devices for the conversion of the energy of electromagnetic radiation ("photocell" hereafter throughout the text) are known; however, until now the principal substantive problem with all devices of this type is their low efficiency.

In particular a photocell [1] is known that includes an inorganic semiconductor, an organic polymer doped with antimony pentachloride, and a semitransparent layer of gold. A deficiency of said photocell is the low efficiency which attains a maximum of only 1.2%.

A photocell [2] is also known that consists of a metallic wafer, a photosensitive layer applied to that wafer that contains a layer of an n-type semiconductor and a layer of poly-ε-epoxypropylcarbazole doped with SbCl₅, and a semitransparent gold film. A deficiency of said photocell is the insufficiently high efficiency of the converter of electromagnetic light radiation energy to electrical energy, which does not exceed 3.2%.

A method of enhancing the efficiency of industrial photocells [3], in which it is proposed that a coating be applied to the surface of the latter capable of converting the blue and ultraviolet portion of the spectrum of electromagnetic radiation incident on the photocell to the long-wavelength region, in which the efficiency of conversion in solid-state devices is higher, is also known (lines 20-25 of page 8 and the last paragraph of page 1 of [3]). In addition, good directionality of the converted radiation is achieved in the known method (lines 35-40 of page 6 of [3]). These effects are achieved by an aggregate of measures, one of which is the use of (nonmetallic) nanocrystals with quantum-size effects (last paragraph of page 2 and first of page 3 of [3]). The idea of modernizing already-existing converters of electromagnetic radiation rather than fabricating new ones must be deemed successful and effective on the whole; however, a deficiency of the known method is the comparative difficulty of the proposed solution, which may lead to complication of the production process and, accordingly, to increased cost of the photocells.

A photocell is also known [4, 5], made based on organic semiconductor material, in which it is proposed to introduce metallic nanoparticles at the p-n transition boundary of the organic photosensitive element, and to use the concentrating of the electromagnetic field near the nanoparticles to enhance the efficiency of the photocell.

The closest in technical essence to the one applied for is the converter of electromagnetic radiation known from [6], which is a tandem solar array that includes two p-n transitions, each of which is formed of two layers of organic materials of the p and n type, the p-n transitions being disposed sequentially, one under the other, and at the site of their junction there is a monolayer of metallic nanoparticles 10 nanometers in diameter. The principal role of the layer of nanoparticles is well known - to achieve the recombination of electrons and holes reaching it from the top and bottom p-n transitions, or, in other words, to prevent the accumulation in the p-n transitions of the charge that could block the functioning of the multi-cascade photocell (see [7], [8], as well as article [9], on the basis of the materials of which the application was written [6]). The essence of the invention [6] consists in the use of an increase in the intensity of the electromagnetic field near the layer of metallic nanoparticles at a wavelength exciting the localized plasmon resonance of the particles (see paragraphs [0025] and [0071] of the application [6]); this may lead to a fairly small (on the order of 15% - see paragraph [0077] of the application [6]) enhancement of the efficiency of generation of the photocurrent.

The principal deficiencies of photocells [4-6] are due to their construction and the materials employed. It should be noted that due to the use of organic semiconductors, the organic photocells are characterized from the start by lower efficiency values as compared with traditional solid-state photocells, for example, those based on silicon or on gallium arsenide, while their principal advantage is their relatively low cost as compared with silicon-based ones. Enhancement of efficiency of the organic photocell even by 15% does not lead to a fundamental increase in effectiveness of the converters. In addition, in the known solutions it is proposed to introduce nanoparticles into the layer of the organic semiconductor, as a result of which, for example, the known solutions cannot be used for the modernization of existing photocells.

### SUMMARY OF THE INVENTION

The objective of the present invention is the creation of a converter of electromagnetic radiation that has an efficiency 1.5-2 times greater than the efficiency of traditional photocells, for example, those based on silicon or on gallium arsenide, and that permits its realization by modification of existing photocells in order to enhance their efficiency.

Said objective is solved by the fact that a converter of electromagnetic radiation that contains at least one photosensitive layer that achieves the generation of a photocurrent through the absorption of electromagnetic radiation, as well as collector electrodes, **according to the invention,** additionally contains metallic nanoparticles, the size of which is of the order of, or less than, the wavelength in the maximum of the spectrum of the incident radiation, that achieve the concentration of the incident radiation in the near-field around the nanoparticles and the generation of a photocurrent through the absorption of said radiation.

In one of the preferred instances of the realization of the invention, said metallic nanoparticles are disposed on the front side of the converter that receives the incident electromagnetic radiation.

In addition, said nanoparticles may be disposed on the surface or within a confining layer applied to the front surface that receives the incident electromagnetic radiation, and further, said confining layer may be a dielectric or semiconductor layer.

In another instance, said nanoparticles may be disposed on the surface of a confining layer applied to the front surface that receives the incident electromagnetic radiation, and covered with a second confining layer applied on top of the first confining layer. In addition, at least one of said confining layers may be a dielectric or semiconductor layer.

In another preferred instance of the embodiment of the invention, said nanoparticles are disposed on the back side of the converter, opposite the side that receives the incident electromagnetic radiation.

In addition, said nanoparticles may be disposed on the surface or within a confining layer applied to the back surface of the converter, and further, said confining layer may be a dielectric or semiconductor layer.

In yet another instance, said nanoparticles may be disposed on the surface of a confining layer applied to the back surface of the converter and covered with a second confining layer applied on top of the first confining layer; in addition, at least one of said confining layers is preferentially a dielectric or semiconductor layer.

In a third preferred instance of the embodiment of the invention, a converter contains at least two photosensitive layers, and between at least two said photosensitive layers there is a layer confining said metallic nanoparticles.

Voltage may be applied to the collector electrodes from an external source when the converter is used, including as a photodetector.

Preferentially, the concentration of nanoparticles within the confining layers is equal to (1 - 75)/100 volume fractions. In disposing the nanoparticles on the surface of the confining layer, it is preferable that the surface density of the nanoparticles on the surface of the confining layer be equal to (1 - 75)/100 volume fractions.

In a particular instance at least one photosensitive layer contains metallic nanoparticles.

Within the framework of the present invention, a layer is understood to be a three-dimensional structure that has at least one common characteristic at every point or section of it (including fabrication from the same material, the presence of a common function, property, etc.), and which at the same time can be separated from the surrounding structures (including layers) physically and/or functionally. It should be noted that a layer may be fabricated from one or several materials, be continuous (including fabricated in the form of a slab), with removals (for example, openings) or, on the other hand, consist of an aggregate of nanocrystals or three-dimensional "island" structures isolated from one another, that nevertheless possess at least one common property, can be separated from the surrounding structures physically or functionally, and are therefore defined and considered within the framework of the invention as a layer.

Further, a photosensitive layer should be understood to be a layer in which, upon absorption of electromagnetic radiation, a photocurrent is generated that is picked up by collector electrodes, for example, a p layer or an n layer or an aggregate of sequentially disposed p and n layers (i.e., layers with hole conduction and electron conduction, respectively). A photosensitive layer according to the invention is preferentially made of solid semiconductor materials, for example, in the form of monocrystal or polycrystal structures or of an aggregate of nanocrystals, including with the formation of p-n transitions in this aggregate.

The surface of the converter that directly receives the incident electromagnetic radiation in the absence of said confining layers will be understood to be the front surface, to which one or several confining layers may be applied. Similarly, the surface of the converter opposite to the front surface in the absence of confining layers will be understood to be the back surface.

The above and other features of the invention including various novel details of construction and combinations of parts, and other advantages, will now be more particularly described with reference to the accompanying drawings and pointed out in the claims. It will be understood that the particular method and device embodying the invention are shown by way of illustration and not as a limitation of the invention. The principles and features of this invention may be employed in various and numerous embodiments without departing from the scope of the invention.

### BRIEF DESCRIPTION OF THE DRAWINGS

In the accompanying drawings, reference characters refer to the same parts throughout the different views. The drawings are not necessarily to scale; emphasis has instead been placed upon illustrating the principles of the invention. Of the drawings:
- in Fig. 1 - schematic drawing of the converter applied for in one of the preferred instances of its embodiment (in cross-section);
- in Fig. 2 - graph of the relationship of the increase in the density of the photocurrent originating upon absorption of solar radiation in the photosensitive layer of the converter applied for, relative to the thickness of this layer;
- in Fig. 3 - spectrum of the absorption and reradiation of broadband electromagnetic radiation by a monolayer of spherical silver nanoparticles;
- in Fig. 4 - spectrum of the predetermined incident electromagnetic radiation which is reradiated by the layer of spherical silver nanoparticles as shown in Fig. 3;
- in Fig. 5 - spectrum of the radiation of individual silver nanoparticles in the example shown also in Figs. 3 and 4.
- in Fig. 6 - distribution of electrostatic fields in the photosensitive layer and in the dielectric confining layer with nanoparticles (on the left) and schema explaining the generation of the photocurrent in the vicinity of a nanoparticle and in the photosensitive layer (on the right).

### DETAILED DESCRIPTION OF THE PREFERRED EMBODIMENTS

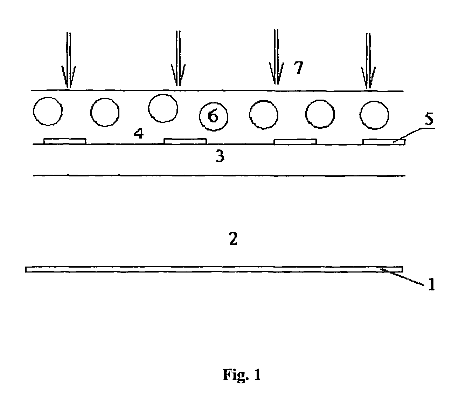

As shown in Fig. 1, the converter in the described specific instance of its embodiment contains a metallic contact (electrode) 1 and a substrate 2. A photosensitive layer 3, in which the generation of a photocurrent takes place upon absorption of incident electromagnetic radiation due to the presence in layer 3 of at least one p-n transition, is disposed on substrate 2. The generation of a photocurrent may partially take place in substrate 2, in the process of which nonequilibrium photoinduced carriers diffuse toward solid contact 1 and stripe contacts 5.

Stripe electrical contacts 5 are disposed on the front surface of the converter formed by the surface of layer 3 turned to the side of the external electromagnetic field 7; solid or non-solid (discontinuous) transparent current-conducting layers (for example, a layer of mixed indium and tin oxide [ITO]) may be used in place of these in other instances of the embodiment of the invention. A solid confining dielectric layer 4, within which metallic nanoparticles 6 are distributed, is applied on top of the front side of photosensitive layer 3 and contacts 5.

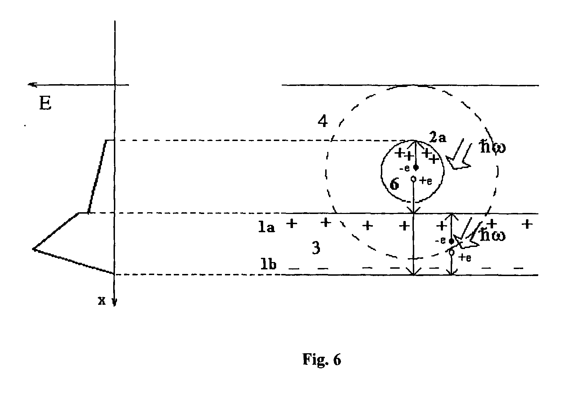

The principal distinction of the converter applied for from photocells known in the prior art is the augmentation of photocurrent density and, as a result, of efficiency, due to two mechanisms that jointly act in the cascades of photocurrent generation of the converter applied for. There are two cascades in the example considered: the first cascade is photosensitive layer 3, and the second cascade is transparent confining dielectric layer 4 with metallic nanoparticles 6 distributed in it (see Figs. 1, 6). The presence of more than two cascades of photocurrent generation (due to an increase in the number of photosensitive and/or confining layers) is possible in other embodiments.

The first mechanism of photocurrent density augmentation is associated with the "concentration" by metallic nanoparticles 6 of an external electromagnetic field (EMF) 7. Metallic nanoparticles 6 absorb and reradiate external EMF 7 of the predetermined spectrum. The metal of nanoparticles 6 and the material of confining layer 4, in which particles 6 are distributed, are selected such that the maximum of the spectrum of the external EMF 7 corresponds to the maximum of the absorption of the EMF by nanoparticles 6 and is close to the localized plasmon resonance (LPR) of nanoparticles 6. Since the size of nanoparticles 6 according to the invention does not exceed the characteristic wavelength of the incident electromagnetic radiation, nanoparticles 6 radiate as dipoles; therefore, scattering of the EMF by nanoparticles 6 does not occur.

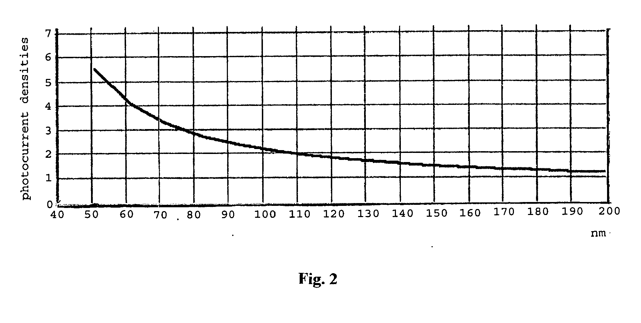

The known formulas of [10, 11] and the known numerical methods based on them can be used for calculations of the parameters of a specific embodiment of the photocell. According to calculations, given the closeness of the maxima of the spectra of the external EMF 7 and the LPR of nanoparticles 6, the density of the energy of the EMF reradiated by nanoparticles 6 at distances from the surface of nanoparticles 6 of 1-2 orders of magnitude of their diameter proves to be several times greater than the energy of the incident EMF; i.e., nanoparticles 6 "concentrate" the EMF of the near-field similarly to the way an ordinary (far-field) EMF is concentrated by lenses or optical resonators. The optimal thickness of photosensitive layer 3, in which the concentration of the EMF by nanoparticles 6 takes place, is 100-200 nm; a more exact value is determined from experiments and by means of numerical calculations for a specific embodiment of the proposed photocell, and depends on the material and form of the nanoparticles and the refractive indices of layers 3 and 4. The concentration of a broadband EMF (such, for example, as the EMF of the solar spectrum) proves to be possible because the LPR spectrum of nanoparticles 6 that interact with one another via the EM near-field is nonuniformly broad, i.e., it consists of a large number of bands, shifted one relative to another and overlapping the spectrum of the prescribed incident EMF. Intense internal fields existing in photosensitive layers with generation of a photocurrent (for example, at p-n transitions) rapidly separate the photoinduced carriers such that they do not have time to recombine [12]; therefore the density of the photocurrent in the first cascade (layer 3) of the proposed converter is proportional to the density of the energy of the EMF reradiated by nanoparticles 6, i.e., it exceeds the density of the generated photocurrent in a similar photocell without nanoparticles by as much a factor as that by which the density of the incident and the reradiated fields differ. The photocurrent augmentation factor in relation to depth h of photosensitive layer 3 is shown in Fig. 2.

Experiments that demonstrate intensification of a photocurrent in a photocell with a covering of spherical silver nanoparticles about 30 nm in diameter have been carried out, in particular, with silicon wafers, 1 cm² in area, with a near-surface p-n transition (photosensitive layer) without nanoparticles on the front side, as well as with silver nanoparticles applied there to a polymer confining layer. The particles are disposed randomly, in the form of a monolayer with a surface density of 0.35, on confining layer 4, for example on a monomolecular layer of polyvinylpyridine (PVP). The effective refractive index of confining layer 4 (depending on the presence of nanoparticles) was taken, according to estimations, to be equal to 3.4. Silver nanoparticles 6 were disposed at a distance of 5 nm from photosensitive layer 3. At a power of the broadband incident electromagnetic radiation of 10 mWt, a photocurrent of about 0.2 mA was observed for silicon without nanoparticles and 0.55 mA in the presence of silver nanoparticles. The p-n transition-silver nanoparticles structure is equivalent to a p-n-n+ transition (two "co-directional" diodes), the combined action of which led, together with the concentration of the EMF by the nanoparticles, to photocurrent intensification as compared with the instance of a p-n transition in silicon without nanoparticles.

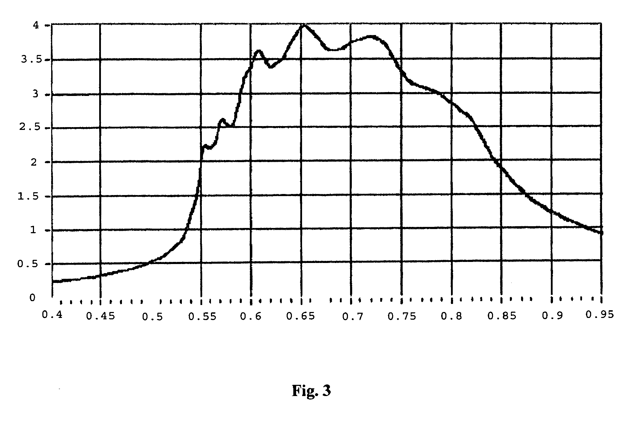

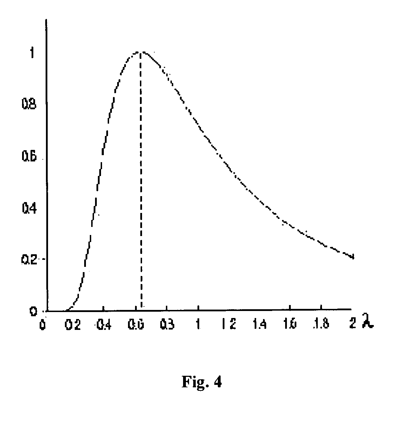

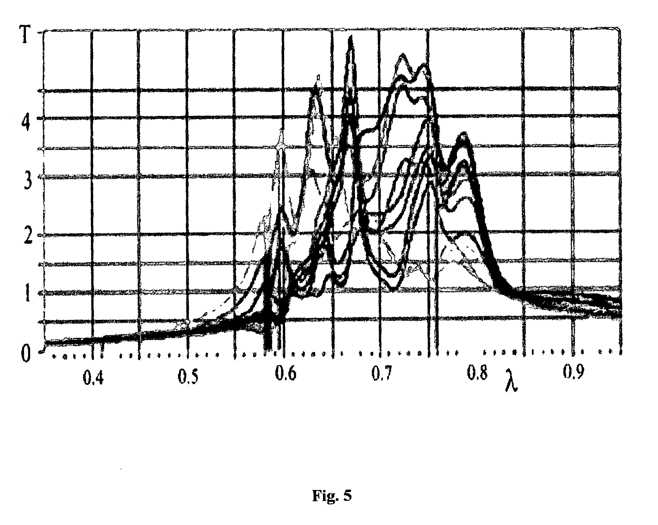

The contribution of the first mechanism - the concentration of the EMF - to photocurrent intensification was determined by means of numerical calculations. The spectra of the electromagnetic radiation absorbed and reradiated by nanoparticles 6 in the design of the converter shown in Fig. 1 are shown in Fig. 3. The width and maximum (650 nm) of the spectrum of the absorption and reradiation of the monolayer of metallic nanoparticles 6 are shown to be close to the corresponding values of the spectrum of incident radiation simulating the solar spectrum (Figs. 4, 6) at a surface density of 0.35 of nanoparticles 6, which is sufficient for effective dipole-dipole interaction of nanoparticles 6 with one another. The latter interaction leads to nonuniform broadening of the spectrum of the absorption and reradiation of the monolayer of metallic nanoparticles 6 as shown in Fig. 5.

The calculation of the contribution was done with the use of known expressions defining the polarizability α of a nanoparticle above the surface, depending upon the form of the nanoparticle and the metal of which it consists, the material of the environment, and the distance to the surface, as well as with the use of known expressions for the dipole radiation of nanoparticles and their dipole-dipole interaction that are cited, for example, in [10, 11] or are derived by direct generalization of the relationships from [10, 11]. A monolayer of N=100 nanoparticles was considered; further increase in the number of particles did not lead to a substantial change in the results of the calculations, including the intensity of the field reradiated by the particles. It should be noted that according to the known relationships for the polarizability α of metallic nanoparticles [10], the maximum of the spectrum of the absorption and reradiation of a monolayer of metallic nanoparticles may also be set close to the maximum of the prescribed spectrum of the incident radiation by selection of the form of the nanoparticles. For example, the maximum of the spectrum of the absorption and reradiation of a monolayer of metallic nanoparticles is shifted toward red if ellipsoidal nanoparticles (of the same material) with major semiaxes lying in the plane of the monolayer of nanoparticles are selected instead of spherical nanoparticles.

According to Fig. 2, the concentration of a broadband EMF by nanoparticles leads to a 1.5-fold increase in the density of the photocurrent generated at a depth of 150 nm which, according to estimates, is the effective depth of the p-n transition of the silicon photocells used in the experiment. An additional increase in the density of the photocurrent, leading ultimately to its augmentation in the experiment from 0.2 mA to 0.55 mA, occurs as a result of the second mechanism.

The second mechanism of the augmentation of photocurrent generation in the proposed converter is associated with the effective generation of photocurrent by metallic nanoparticles 6 themselves, as they interact with the environment in the second cascade of the photocell (in confining layer 4), which proves to be possible, including due to strong local electrostatic fields existing close to nanoparticles 6. It is material that the generation of photocurrent by metallic nanoparticles 6 takes place close to their surface, i.e., precisely where the nanoparticles effectively concentrate the EMF.

The near-surface volume of photosensitive layer 3 (for example, of the p-n transition of the silicon photocells) where the generation of photocurrent takes place, proves to be charged due to the separation of free carriers by the internal electrostatic fields of layer 3. For definiteness we shall presume that the free carriers of layer 3 are separated as shown in Fig. 6, in which the additional positions are designated as follows: 1a, 1b - spatially separated charges of the photosensitive layer; 2a - the positive charge of the nanoparticle; -e and +e - photoinduced carriers, electrons and holes, respectively; and the dotted circle designates the region of concentration of the electromagnetic field by nanoparticle 6.

The metallic nanoparticles 6 of layer 4 are preferentially shifted a small distance (several nm) from the charged volume of layer 3; therefore conduction electrons can tunnel through thin layer 4 of the dielectric (in the example described - PVP) that separates particle 6 from layer 3. When a photon of energy □ω is absorbed, electron-hole pairs -e+e arise in layer 3 or in nanoparticle 6, the electrons and holes of which are separated by internal fields, the qualitative distribution E(x) (the force acting on a unit positive charge) of which is shown in Fig. 6 on the left. That part of E(x) that relates to layer 4 corresponds to the mean field in layer 4, the effective thickness of which is taken to be equal to the diameter of nanoparticle 6 plus the distance from the upper boundary of layer 3 to the surface of nanoparticle 6. Beyond the boundaries of regions with built-in electrostatic fields, the photoinduced carriers diffuse toward the anode and cathode - contacts 1 and 5 in Fig. 1.

The local fields close to nanoparticles 6 differ from that shown in Fig. 6. In particular, the electrostatic fields within nanoparticles 6 are close to 0, while those close to nanoparticles 6 substantially exceed the mean field E(x) indicated in Fig. 6. Since the local electrostatic field close to nanoparticle 6 is induced by the charges of photosensitive layer 3 that are concentrated close to the nanoparticle, this field proves to be of the order of, or greater than the internal field in layer 3 (for example, in the p-n transition), which is very large. The strong local fields close to the nanoparticles promote effective separation of the photoinduced carriers similar to the way this occurs in the region of a Schottky barrier [12], thereby enhancing the effectiveness of the generation of the photocurrent. For example, if photosensitive layer 3 is a semiconductor, then a nanoparticle 6 close to the surface of the semiconductor forms a "semiconductor-metal" (SM) or a "semiconductor-dielectric-metal" (SDM) transition where, as in p-n transitions, the strong internal electrostatic fields of a double layer of charges arise [13]. These fields effectively separate the carriers photoinduced when the EMF is absorbed by nanoparticles 6. If photosensitive layer 3 is a semiconductor and the contribution of electron states at the contacting surface of layers 3 and 4 is negligible, then the work function for the electrons of the nanoparticle should be less (more) than in the adjacent region of the semiconductor, if this region is of the n (p) type, as occurs in the case of experiments with silver nanoparticles in silicon (see above).

The work function of an electron from a metallic nanoparticle 6 which is in a strong electrostatic field is substantially decreased as compared with the usual magnitude of the work function of an electron (hole) from the corresponding metal [12]. This facilitates the escape of photoinduced carriers beyond the boundaries of the nanoparticle and leads to an additional enhancement of the generation of the photocurrent when the EMF is absorbed by nanoparticles 6. The size of nanoparticle 6 is preferentially selected to be less than the length of the free path of the electrons in the metal (several hundreds of nm), as a result of which the probability for photoinduced carriers to reach the surface of nanoparticle 6, to escape beyond its boundaries, and to make a contribution to the photocurrent is increased.

Thus, the generation of the photocurrent in the proposed photocell is achieved not only in the region of photosensitive layer 3, as in the known photocells, but also within nanoparticles 6 and close to their surfaces, i.e., precisely where nanoparticles especially effectively concentrate an electromagnetic field, in addition to the region of concentration of the EMF (bounded by the broken circle in Fig. 6) in photosensitive layer 3. The set of regions of photocurrent generation localized close to the nanoparticles (as, for example, SM or SDM transitions, if photosensitive layer 3 is a semiconductor) form a second "heterogeneous" cascade of photocurrent generation in addition to the cascade formed by photosensitive layer 3. In the example considered (in the experiment with silver nanoparticles in silicon), the simultaneous action of the two mechanisms described led to a more than 2-fold enhancement of the efficiency of the converter.

Another advantage of the converter applied for, along with the tandem generation of the photocurrent, is the possibility of its creation by modernization of standard industrially produced solid-state photocells. In particular, a dielectric confining layer containing metallic nanoparticles can be applied in the form of a film to the front or back surface of a silicon photocell. Nanoparticles can also be disposed on the surface of a dielectric layer in air or on the surface of one dielectric confining layer, but be closed from above by a layer of another or the same dielectric. The possibility of the use of a semiconductor for the formation of the confining layer is not excluded.

The choice of the side of the converter for the disposition of the layer of nanoparticles depends mainly on the thickness of the photosensitive layer. In the case of a comparatively thick photosensitive layer, for the achievement of a substantial contribution of the nanoparticles to the generation of the photocurrent it is preferable to place them on the front surface, since a significant absorption of the EMF in the photosensitive layer and weak penetration of radiation to the back side of such a converter makes the placement of the layer of nanoparticles on the back side of the converter inadvisable. By contrast, the placement of the layer of nanoparticles on the back side in the case of a comparatively thin photosensitive layer is fully justified.

Another preferred instance of the realization of the invention may be the placement of the layer of nanoparticles between two photosensitive layers. Obviously it is preferable to use this option for the fabrication of new converters and not for the modernization of existing ones.

In particular, the standard semiconductor wafer, for example, of the p type, can be doped on one side with an n-type mixture to a predetermined depth, for example, 100-250 nm, by the method of diffusion of ions from a gas phase. A continuous metal contact can be applied to the other side of a p-type wafer, for example, by the vacuum deposition method.

Further, to obtain a new converter, metal stripe contacts can be applied to the side of the wafer doped with the n-type mixture, and then, a monomolecular layer of polymer, to which are applied metallic nanoparticles, for example, by precipitation from a hydro- or organosol. Metal stripe contacts can also be applied not to a silicon wafer but to a layer of polymer with nanoparticles.

To obtain a multi-cascade converter, instead of the application of metal contacts on top of the layer of nanoparticles, a p-type semiconductor layer can be deposited, doped further with n-type mixtures, with the subsequent application of current-conducting contacts to the doped surface. Thus the layer of nanoparticles is found to be placed between two photosensitive layers. Obviously a converter can also contain three or more photosensitive layers, and when necessary a confining layer with nanoparticles can be placed between two neighboring photosensitive layers.

In addition, in accordance with known prior art [14], the photosensitive layers themselves may also contain metallic nanoparticles to intensify the field within a p-n transition through excitation of the LPR of nanoparticles.

It should be noted in conclusion that the above-cited examples do not encompass all possible instances of the embodiment of the invention, are intended exclusively for better understanding of it and for demonstration of the achievement of the technical result, and may not be regarded as limiting the scope of the legal protection requested. The specialist understands that other particular instances of the embodiment of the invention applied for are possible - in particular, depending on the refractive index of confining layer 4 required, it can be made of semiconductor material; the converter can be fitted with several confining layers with nanoparticles that can be disposed both on the front side and the back side, and (in addition, to the front and the back side) between photosensitive layers is also possible; on the back side of the converter a confining layer can be applied both on top of electrode 1 as well as directly on top of substrate 2 with the subsequent application of electrode 1 on top of the confining layer. Also possible are other particular instances of the embodiment of the invention not directly mentioned in the above-described non-restrictive examples but nevertheless not beyond the limits of the scope of the requested legal protection, to be defined exclusively by the attached claims.

While this invention has been particularly shown and described with references to preferred embodiments thereof, it will be understood by those skilled in the art that various changes in form and details may be made therein without departing from the scope of the invention encompassed by the appended claims.

### SOURCES OF INFORMATION

1. SU 1801232 A3, Guba et al., 07.03.1993
2. SU 1806424 A3, Guba et al., 30.03.1993
3. WO 2006/034561 A1, Gaponenko et al., H01L 31/02, published 06.04.2006
4. M. Brongersma et al., "Nanostructured metal-organic composite solar cells", Stanford University, GCEP project, Sept. 2005 - Aug. 2008.
5. M. Brongersma et al., "Nanostructured metal-organic composite solar cells", Stanford University, GCEP Technical Report 2006.
6. US 2006032529 A1, Rand et al., H01L 31/00, published 16.02.2006.
7. A. Yakimov and S. R. Forrest, Appl. Phys. Lett. v. 80, p.1667, 2002.
8. B. Maennig et al., Appl. Phys. A: Mater. Sci. Process. v. 79, p. 1, 2004.
9. B. P. Rand, P. Peumans, and S. R. Forrest, "Long-range absorption enhancement in organic tandem thin-film solar cells containing silver nanoclusters ", Journal of Applied Physics, v.96, p. 7519, 2004.
10. L. D. Landau and E. M. Lifshits, Elektrodinamika sploshnykh sred [Electrodynamics of Continuous Media] [in Russian], Moscow, Fizmatlit, 2001, p. 66.
11. L. D. Landau and E. M. Lifshits, Teoriya polya [Field Theory] [in Russian] Moscow, Nauka, 1988, p. 253.
12. S. Sze, Physics of Semiconductor Devices [Translated into Russian as Fizika poluprovodnikovykh priborov], Book 2, Moscow, Mir, 1984, p. 403.
13. R. Bube, Photoconductivity of Solids [Translated into Russian as Fotoprovodimost' tverdykh tel], Moscow, Izd-vo Inostrannoy literatury, 1962, p. 144.
14. RU 2217845 C1, ZAYMODOROGA, O. A. ET AL., *H01L 31*/*04,* PUBLISHED 27.11.2003.

## Claims

1. A converter of electromagnetic radiation that contains at least one photosensitive layer that achieves the generation of a photocurrent through the absorption of electromagnetic radiation, as well as collector electrodes, **distinguished by the fact that** it also contains metallic nanoparticles, by size of the order of, or less than the wavelength in the maximum of the spectrum of the incident radiation, that achieve the concentration of the incident radiation in the near-field around the nanoparticles and the generation of a photocurrent through the absorption of said radiation.

2. A converter according to claim 1, distinguished by the fact that said nanoparticles are disposed on the front side of the converter that receives the incident electromagnetic radiation.

3. A converter according to claim 2, distinguished by the fact that said nanoparticles are disposed on the surface of a confining layer applied to the front surface that receives the incident electromagnetic radiation.

4. A converter according to claim 2, distinguished by the fact that said nanoparticles are disposed within a confining layer applied to the front surface that receives the incident electromagnetic radiation.

5. A converter according to claim 3 or 4, distinguished by the fact that said confining layer is a dielectric or semiconductor layer.

6. A converter according to claim 2, distinguished by the fact that said nanoparticles are disposed on the surface of a confining layer applied to the front surface that receives the incident electromagnetic radiation, and covered with a second confining layer applied on top of the first confining layer.

7. A converter according to claim 6, distinguished by the fact that at least one of said confining layers is a dielectric or semiconductor layer.

8. A converter according to claim 6, distinguished by the fact that at least one of said confining layers is a semiconductor layer.

9. A converter according to claim 1, distinguished by the fact that said nanoparticles are disposed on the back side of the converter, opposite the side that receives the incident electromagnetic radiation.

10. A converter according to claim 9, distinguished by the fact that said nanoparticles are disposed on the surface of a confining layer applied to the back surface of the converter.

11. A converter according to claim 9, distinguished by the fact that said nanoparticles are disposed within a confining layer applied to the back surface of the converter.

12. A converter according to claim 10 or 11, distinguished by the fact that said confining layer is a dielectric or semiconductor layer.

13. A converter according to claim 9, distinguished by the fact that said nanoparticles are disposed on the surface of a confining layer applied to the back surface of the converter and covered with a second confining layer applied on top of the first confining layer.

14. A converter according to claim 13, distinguished by the fact that at least one of said confining layers is a dielectric or semiconductor layer.

15. A converter according to claim 1, distinguished by the fact that between at least two photosensitive layers there is a layer confining said metallic nanoparticles.

16. A converter according to claim 1, distinguished by the fact that voltage may be applied to the collector electrodes from an external source.

17. A converter according to any of claims 4, 6-8, 11, 13, and 14, distinguished by the fact that the concentration of the nanoparticles within the confining layers is equal to (1 - 75)/100 volume fractions.

18. A converter according to claim 3 or 10, distinguished by the fact that the surface density of the nanoparticles on the surface of the confining layer is equal to (1 - 75)/100 volume fractions.

19. A converter according to any of claims 1-4, 6-11, and 13-16, distinguished by the fact that at least one photosensitive layer contains metallic nanoparticles.

20. A converter according to claim 5, distinguished by the fact that at least one photosensitive layer contains metallic nanoparticles.

21. A converter according to claim 12, distinguished by the fact that at least one photosensitive layer contains metallic nanoparticles.

22. A converter according to claim 17, distinguished by the fact that at least one photosensitive layer contains metallic nanoparticles.

23. A converter according to claim 18, distinguished by the fact that at least one photosensitive layer contains metallic nanoparticles.
